(19) Europäisches Patentamt
European Patent Office
Office européen des brevets

(11) **EP 2 251 179 B1**

(12) **EUROPÄISCHE PATENTSCHRIFT**

(45) Veröffentlichungstag und Bekanntmachung des Hinweises auf die Patenterteilung:
**21.12.2011 Patentblatt 2011/51**

(21) Anmeldenummer: **10162142.3**

(22) Anmeldetag: **06.05.2010**

(51) Int Cl.:
**B29C 47/92** *(2006.01)*     **G01R 31/02** *(2006.01)*
**H01B 13/14** *(2006.01)*

(54) **Vorrichtung zur Untersuchung einer Drahtbeschichtung**

Device for inspecting a wire coating

Dispositif destinés à l'examen d'un revêtement de fil

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **08.05.2009 DE 102009020528**

(43) Veröffentlichungstag der Anmeldung:
**17.11.2010 Patentblatt 2010/46**

(73) Patentinhaber: **Schwering & Hasse Elektrodraht GmbH**
**32676 Lügde (DE)**

(72) Erfinder: **Manazza, Massimo**
**32676 Lügde OT Sabbenhausen (DE)**

(74) Vertreter: **Herzog, Markus et al**
**Weickmann & Weickmann**
**Patentanwälte**
**Postfach 86 08 20**
**81635 München (DE)**

(56) Entgegenhaltungen:
**CH-A- 434 460     DE-A1- 10 239 460**
**GB-A- 974 741     US-A- 5 416 419**

**Beschreibung**

Die vorliegende Erfindung betrifft eine Vorrichtung zur Untersuchung einer Drahtbeschichtung eines entlang einer Laufrichtung bewegten Drahts.

Vorrichtungen und Verfahren dieser Art kommen im Stand der Technik im Bereich der Herstellung oder Verarbeitung elektrischer Drähte zum Einsatz. Solche Drähte sind im allgemeinen aus einem leitfähigen Drahtkern, z. B. einem Kupferdraht, und einer den Drahtkern umgebenden Drahtbeschichtung aufgebaut. Die Drahtbeschichtung dient vornehmlich der elektrischen Isolierung und kann eine Vielzahl einzelner Schichten umfassen, um spezielle Anforderungen an die Isolierung, Elastizität und Gleitfähigkeit des Drahts zu erfüllen. Ein wichtiges Anwendungsfeld liegt auf dem Gebiet der Produktion von Kupferlackdraht, welcher in einem Inline-Verfahren hergestellt wird. In der dafür verwendeten Herstellungsanlage wird der Kupferdraht in einer ersten Station gezogen, in einer zweiten Station lackiert, d. h. mit einer Drahtbeschichtung überzogen, und in einer weiteren Station auf einer Lieferspule aufgewickelt, so dass ein quasi endloser Fertigungsbetrieb möglich ist.

Die Herstellung und Verarbeitung solcher Drähte, insbesondere von Kupferlackdraht, unterliegt ständig wachsenden Qualitätsanforderungen. Dabei kommt insbesondere der Drahtbeschichtung eine wichtige Rolle in Hinblick auf die Isolationseigenschaften oder mechanischen Eigenschaften zu, so dass die Qualitätskontrolle der Drahtbeschichtung eine wichtige Herausforderung für die technische Entwicklung auf diesem Gebiet darstellt. Vor allem gilt es, Schwachstellen der Beschichtung, die die Gefahr einer unzureichenden Isolierung und somit im schlimmsten Fall die Gefahr eines Kurzschlusses in sich bergen, sicher aufzuspüren, um den entsprechenden Abschnitt des Drahts von der Weiterverarbeitung oder Auslieferung auszuschließen.

Zur Untersuchung der Drahtbeschichtung eines Drahts sind im Stand der Technik Vorrichtungen bekannt, welche an einer Messposition nach dem Austritt des Drahts aus einer Beschichtungsstation eine Messspannung an die Drahtbeschichtung anlegen und einen über die Drahtbeschichtung fließenden Strom messen. Ein über einen Normalwert erhöhter Stromfluss zeigt dann eine fehlerhafte Isolierung, d. h. eine Schwachstelle der Drahtbeschichtung, an und erlaubt die Aussonderung des entsprechenden Abschnitts des Drahts oder die Unterbrechung der Fertigung.

Bei den bekannten Vorrichtungen hat sich herausgestellt, dass auch bei intakter Drahtbeschichtung unter verschiedenen Fertigungsbedingungen gewisse Ströme über die Messelektrode fließen, welche schwer vorhersehbar sind und eine genaue Identifizierung eines Fehlers der Drahtbeschichtung erschweren. Diese Messströme wurden darauf zurückgeführt, dass die Drahtbeschichtung als Dielektrikum wirkt und somit beim Passieren der Messelektrode elektrisch polarisiert wird. Ähnlich der Einführung eines Dielektrikums in einen Plattenkondensator kommt es zu einer Verschiebung von Ladungsschwerpunkten innerhalb des Dielektrikums, d. h. innerhalb der Drahtbeschichtung, was zu einem gewissen Stromfluss über die Messelektrode führt. Da der Draht kontinuierlich durch die Messelektrode hindurch geführt wird, hält dieser Polarisierungsstrom auch kontinuierlich an, so dass auch bei intakter Drahtbeschichtung ein von Null verschiedener Messstrom auftritt.

Um dieses Problem zu lösen, wurde im Stand der Technik bereits die Bereitstellung einer Voraufladungselektrode in Betracht gezogen, über welche die Hochspannung nicht nur am Ort der tatsächlichen Erfassung des Messstroms sondern auch an einem in Laufrichtung des Drahts vorausgehenden Ort an die Drahtbeschichtung angelegt wird, so dass die Drahtbeschichtung am Ort der Voraufladungselektrode bereits polarisiert oder aufgeladen wird. Somit läuft dann Draht mit einer bereits polarisierten Drahtbeschichtung durch die Messelektrode, so dass bei intakter Drahtbeschichtung kein zusätzlicher Strom über die Messelektrode fließen sollte. Messelektrode und Voraufladungselektrode sind bei den bekannten Vorrichtungen über einen Spannungsteiler an eine Spannungsquelle angeschlossen, um die Spannung der Spannungsquelle zu gleichen Teilen an beiden Positionen des Drahts anzulegen.

Im praktischen Einsatz hat die bekannte Vorrichtung zwar zu verbesserten Ergebnissen, jedoch noch immer zu teils erheblichen, nicht kontrollierbaren und von der Geschwindigkeit des Drahts stark abhängigen Messfehlern geführt. Insbesondere beeinflussen die teils rauen Produktionsbedingungen in der Umgebung einer Beschichtungsstation des Drahts teils signifikant und unvorhersehbar die Ergebnisse der Untersuchung der Drahtbeschichtung, die auf einer hoch genauen Messung von kleinsten Fehlerströmen, z. B. im Bereich von ungefähr 5 μA bis ungefähr 20 μA, basiert.

Ein weiterer Nachteil herkömmlicher Vorrichtungen und Verfahren liegt in der relativ komplizierten Auswertung der Untersuchungsergebnisse. Die über einen relativ großen Weg entlang der Laufrichtung des Drahts verteilten Schaltungen für Voraufladungselektrode, Messelektrode, Auswerteeinheit usw. sind zumeist über ein aufwendig zu installierendes Verkabelungssystem verbunden und darüber hinaus an eine Auswerterecheneinheit angeschlossen, welche in einem entfernten Überwachungsraum, zumeist anhand von Computern, die Ergebnisse der Untersuchung auswertet und anzeigt. Die Stationierung der herkömmlichen Auswertesysteme (insbesondere Computeranlagen) in einer entfernteren Position, insbesondere in einem abgetrennten Raum, wird im Stand der Technik als wichtige Maßnahme angesehen, um die Auswerteeinrichtungen vor den rauen Produktionsbedingungen der Herstellungsanlage und vor allem der Beschichtungsstation zu schützen. Als nachteilig hat sich jedoch herausgestellt, dass eine unmittelbare Überwachung des Beschichtungsvorgangs und der Qualität des hergestellten Drahts vor Ort und somit eine schnelle Reaktion auf einen fehlerhaften Betrieb der Beschichtungsstation nicht möglich sind.

Die CH 434 460 A offenbart eine Vorrichtung zur Untersuchung einer Drahtbeschichtung eines entlang einer Laufrichtung bewegten Drahts gemäß den Merkmalen des Oberbegriffs des Anspruchs 1. Die bekannte Vorrichtung umfasst eine Voraufladungselektrode, die auf eine Voraufladungsspannungsversorgung angeschlossen ist, sowie eine Messelektrode, die an eine Messspannungsversorgung angeschlossen ist, wobei die Voraufladungselektrode und die Messelektrode im Abstand voneinander entlang der Laufrichtung des Drahts in Kontakt mit der Drahtbeschichtung gebracht sind. Ein im Stromkreis der Messelektrode angeordneter Zähler zählt die Anzahl von Entladungen über die Drahtbeschichtung, die auf einen Fehler der Drahtbeschichtung hinweisen.

Zur weiteren Illustration des Stands der Technik kann auf die DE 102 39 460 A1 hingewiesen werden, welche eine Vorrichtung zur kontinuierlichen elektrischen Prüfung einer Drahtbeschichtung offenbart, in welcher der Draht über eine erste Laufrolle geführt wird, an welcher eine elektrische Ladung auf die Oberfläche der Drahtbeschichtung aufgebracht wird, und über eine zweite Laufrolle geführt wird, an welcher die Isolation der Drahtbeschichtung auf Fehlstellen geprüft wird.

Vor diesem Hintergrund ist es Aufgabe der vorliegenden Erfindung, eine Vorrichtung zur Untersuchung einer Drahtbeschichtung eines entlang einer Laufrichtung bewegten Drahts bereitzustellen, mit welchen eine genauere und zuverlässigere Erkennung von Fehlern der Drahtbeschichtung möglich ist und welche den Einsatz einfacherer Mittel zur Ermittlung eines solchen Fehlers sowie zur Signalisierung eines solchen Fehlers erlauben.

Zur Lösung dieser Aufgabe stellt die vorliegende Erfindung eine Vorrichtung gemäß Anspruch 1 bereit.

Anzumerken ist, dass unter der "Laufrichtung" des Drahts eine in Richtung des Verlaufs des Drahts durch die Vorrichtung hindurch weisende Richtung zu verstehen ist, welche nicht notwendigerweise geradlinig sein muss. Ein Abstand zwischen Voraufladungsposition und Messposition in Laufrichtung des Drahts ist somit entlang des Verlaufs des Drahts zu messen und kann daher größer sein als eine geradlinige Verbindung zwischen Voraufladungsposition und Messposition.

Ein wichtiges Merkmal der vorliegenden Erfindung ist die Bereitstellung von galvanisch getrennten Spannungsausgängen für Voraufladungsspannungsversorgung und Messspannungsversorgung. Unter einer galvanischen Trennung oder galvanischen Entkopplung wird eine elektrische Trennung oder Entkopplung der Spannungsausgänge verstanden, welche im Wesentlichen vollständig einen Austausch von Ladungsträgern zwischen die Voraufladungsspannung tragenden Kontakten und die Messspannung tragenden Kontakten verhindert. Zwar können zwischen diesen beiden Stromkreisen Kopplungsglieder angeordnet sein (z. B. eine später noch näher zu beschreibende Überwachungsschaltung oder dergleichen), um elektrische Leistung oder Signale oder Information zwischen den beiden entkoppelten Stromkreisen zu übertragen, jedoch erfolgt im Wesentlichen kein Übergang von Ladungsträgern zwischen den Stromkreisen.

In einer einfachen und sicheren Art der Realisierung einer solchen galvanischen Entkopplung kann die Vorrichtung zwei galvanisch getrennte, separate Hochspannungsquellen für Voraufladungsspannung bzw. für Messspannung bereit stellen. Kommt für die Hochspannungsquellen jeweils ein Transformator zum Einsatz, so könnten zwar die Primärseiten der Transformatoren an einer gemeinsamen Energiequelle angeschlossen sein. Zur Erzielung der erfindungsgemäßen Effekte weisen dann jedoch Voraufladungsspannungsversorgung und Messspannungsversorgung jeweils separate, von einander galvanisch getrennte Sekundärstromkreise auf, die einen Austausch von Ladungsträgern zwischen den beiden Spannungsversorgungen verhindern.

Durch die erfindungsgemäße galvanische Trennung der Spannungsausgänge für Voraufladungsspannungsversorgung und Messspannungsversorgung konnte in der Praxis eine überraschend zuverlässige und genaue Erfassung eines Stromflusses über die Messelektrode erreicht werden. Insbesondere war es möglich, auch unter rauen Produktionsbedingungen in der Umgebung einer Beschichtungsstation Messströme über die Messelektrode sicher zu erfassen und eine zuverlässige Fehlererkennung zu gewährleisten.

In einer bevorzugten Ausführungsform der Erfindung ist die Voraufladungsspannungsversorgung zur Einstellung unterschiedlicher Voraufladungsspannungen verstellbar. Alternativ oder zusätzlich kann die Messspannungsversorgung zur Einstellung unterschiedlicher Messspannungen verstellbar sein. Durch die verstellbare Spannungsversorgung kann insbesondere die Voraufladungsspannung in einfacher Weise an die tatsächlichen Produktionsbedingungen angepasst werden, so dass eine einfache Abstimmung der Vorrichtung auf die tatsächlich vorherrschenden Bedingungen möglich ist. So ist die auf die Drahtbeschichtung übertragene Ladungsmenge und die durch dielektrische Relaxation auf dem Weg zur Messelektrode verschwindende Ladungsmenge vom Material der Beschichtung oder von der Geschwindigkeit, mit der der Draht die Anlage durchläuft, abhängig, so dass Änderungen in der Laufgeschwindigkeit des Drahts durch eine Verstellung von Voraufladungsspannung oder/und Messspannung ausgeglichen werden können.

In einer weiteren bevorzugten Ausführungsform umfasst die Vorrichtung eine Positionierungseinrichtung zur Verstellung des Abstandes zwischen Voraufladungselektrode und Messelektrode. Durch die Veränderung des Abstandes zwischen Voraufladungselektrode und Messelektrode kann auf einen Ladungszustand der Drahtbeschichtung am Ort der Messelektrode Einfluss genommen werden. Dies geht darauf zurück, dass die von der Voraufladungselektrode auf die Drahtbeschichtung übertragene Voraufladung aufgrund dielektrischer Relaxation mit einer materialabhängigen Zeitkonstante abklingt. Das heißt, es tritt nach der Voraufladung eine kontinuierliche Dipolarisierung oder Entladung mit exponentieller zeitlicher Abklinkkurve auf. Ein Ladungszustand der Drahtbeschichtung am Ort der Messelektrode ist somit gegeben durch die Voraufladungsspannung, eine Geschwindigkeit des Drahts auf dem Weg von der Vorauflaudungsposition zur Messposition, dem Abstand zwischen Voraufladungsposition und Messposition sowie Materialparametern der Drahtbeschichtung. Durch die Bereitstellung der Positionierungseinrichtung ermöglicht die vorgenannte Ausführungsform der Erfindung somit eine flexible Anpassung der Vorrichtung an verschiedener Produktionsumgebungen und Produktionsparameter, z. B. eine Anpassung an die Geschwindigkeit des Drahts, an verschiedene Drahtbeschichtungen oder dergleichen.

Für einen automatisierten Betrieb der Vorrichtung wird ferner eine Steuer-/Regeleinrichtung vorgeschlagen, welche einen Eingang für die Eingabe einer Betriebsgröße aufweist, wobei die Steuer-Regeleinrichtung die Voraufladungsspannung oder/und die Messspannung oder/und den Abstand zwischen Voraufladungselektrode und Messelektrode in Abhängigkeit der mindestens einen eingegebenen Betriebsgröße einstellt. Die Betriebsgröße kann dabei ausgewählt sein aus: Voraufladungsspannung, Messspannung, Abstand zwischen Voraufladungselektrode und Messelektrode, Geschwindigkeit des Drahts in Laufrichtung und eine die Drahtfertigungsumgebung repräsentierende Größe. Diese bevorzugten Betriebsgrößen haben direkten Einfluss auf die von der Vorrichtung ermittelten Messergebnisse, insbesondere auf den Stromfluss über die Messelektrode. Die Eingabe einer Betriebsgröße in die Steuerregeleinrichtung kann vorteilhaft über eine bekannte, geeignete Schnittstelle, z. B. eine Drahtverbindung, eine Funkverbindung oder dergleichen erfolgen. Wahlweise kann eine Betriebsgröße auch über eine Nutzerschnittstelle manuell eingegeben werden, so z. B. eine Geschwindigkeit des Drahts oder eine die Drahtfertigungsumgebung repräsentierende Größe (Drahtbeschichtungsmaterial, Temperatur etc.). Vorzugsweise wird die Messspannung auf das untersuchte Kabel abgestimmt und konstant gehalten. Ebenso wird vorzugsweise der Abstand zwischen Voraufladungselektrode und Messelektrode konstant gehalten. Die Voraufladungsspannung wird dann in Abhängigkeit von der Messspannung vom Abstand und von äußeren Bedingungen und Einflüssen eingestellt.

Erfindungsgemäß ist vorgesehen, dass die Voraufladungsspannungsversorgung und die Messspannungsversorgung über eine Überwachungsschaltung miteinander gekoppelt sind, welche für einen Vergleich zwischen der Voraufladungsspannung und der Messspannung oder zwischen diese Spannungen repräsentierenden Größen eingerichtet ist. Eine derartige Überwachungsschaltung ermöglicht es, dass sich Voraufladungsspannungsversorgung und Messspannungsversorgung gegenseitig in Bezug auf ihre Spannung oder/und in Bezug auf die fließenden Ströme überwachen. Da insbesondere die bei intakter Drahtbeschichtung fließenden Messströme äußerst gering sein können und sehr empfindlich von der genauen Größe (dem Verhältnis) der relativ großen Voraufladungsspannung und Messspannung abhängen, ermöglicht eine solche Überwachungsschaltung in einfacher Weise die zuverlässige Sicherstellung einer definierten Relativbeziehung zwischen Voraufladungsspannung und Messspannung. Ein zusätzlicher Aufwand für die Stabilisierung oder Überwachung der beiden Spannungen kann reduziert werden.

Vorzugsweise gibt die Überwachungsschaltung ein Vergleichsergebnis des Vergleichs an die Steuerregeleinrichtung aus und die Steuerregeleinrichtung steuert/regelt die Voraufladungsspannung oder/und die Messspannung oder/und den Abstand zwischen Voraufladungselektrode und Messelektrode in Abhängigkeit von dem Vergleichsergebnis. Auf diese Weise wird ein Regelkreis geschaffen, welcher in einfacher Weise eine stabile und sehr genaue Relativbewegung zwischen Voraufladungsspannung und Messspannung gewährleistet.

In jedem Falle erhält jedoch die Überwachungsschaltung die erfindungsgemäße galvanische Trennung der Spannungsausgänge von Voraufladungsspannungsversorgung und Messspannungsversorgung aufrecht, beispielsweise indem die Überwachungsschaltung einen Komparator umfasst, welcher (z. B. durch mindestens ein Entkopplungsglied) von den Spannungsausgängen galvanisch getrennt ist.

Ferner umfasst die Vorrichtung eine Fehlerdiagnoseeinrichtung, welche auf Grundlage einer Spannung oder/und eines Stroms über die Voraufladungselektrode oder/und auf Grundlage einer Spannung oder/und eines Stroms über die Messelektrode einen Fehlerzustand in der Vorrichtung erfasst. Auf diese Weise wird eine Selbstdiagnosefunktion bereitgestellt, mit welcher unzulässige Abweichungen von Soll-Betriebszuständen der Vorrichtung erfasst werden können. Ein solcher Fehlerzustand muss nicht in einem Fehler der Drahtbeschichtung liegen. Mit der vorgeschlagenen Fehlerdiagnoseeinrichtung lassen sich auch andere Betriebsstörungen der Vorrichtung erfassen. Vorzugsweise wertet die Fehlerdiagnoseeinrichtung sowohl Spannung als auch Strom aus.

Um die Vorrichtung an bestimmte Produktionsumgebungen und Produktionsbedingungen einfach oder sogar automatisch anpassen zu können und eine Kalibrierung der Vorrichtung vornehmen zu können, wird ferner daran gedacht, dass die Messanordnung den erfassten Messelektrodenstromfluss an die Steuer-/Regeleinrichtung ausgibt, und dass die Steuer-/Regeleinrichtung die Voraufladungsspannung oder/und die Messspannung oder/und den Abstand zwischen Voraufladungselektrode und Messelektrode in Abhängigkeit von dem Messelektrodenstromfluss steuert/regelt. Auf diese Weise wird eine einfache Regelschaltung zur Anpassung oder zur Kalibrierung der Vorrichtung an gegebene Betriebsverhältnisse bereitgestellt.

Wenn der Draht die Voraufladungselektrode verlässt, so trägt der Draht eine der Voraufladungsspannung entsprechende Voraufladung, welche aufgrund dielektrischer Relaxation im Zeitverlauf abklingt. An der Messposition ist die Voraufladung auf einen Wert abgeklungen, der einer Spannung entspricht, die niedriger ist als die Vorauofladungsspannung. Wenn nun die Messspannung im Wesentlichen dieser niedrigeren Spannung entspricht, so kommt es beim Anlegen der Messspannung nicht zu einer weiteren Polarisierung bzw. Aufladung und gleichzeitig wird auch im Wesentlichen keine von der Voraufladung des Drahts herrührende Ladung auf die Messelektrode fließen. Unter der Annahme einer optimalen Isolierung durch die Drahtbeschichtung würde dann im Wesentlichen kein Messstrom fließen.

Ein möglichst kleiner Messstrom, insbesondere ein im Wesentlichen nicht vorhandener Messstrom, vergrößert jedoch die Erfassungsgenauigkeit einer Unregelmäßigkeit der Drahtbeschichtung. In einer vorteilhaften Ausführungsform ist daher vorgesehen, dass die Steuerregeleinrichtung die Voraufladungsspannung oder/und die Messspannung oder/und den Abstand zwischen Voraufladungselektrode und Messelektrode so einstellt, dass im Falle einer ordnungsgemäßen Drahtbeschichtung ein minimaler Strom oder im Wesentlichen kein Strom über die Messelektrode fließt. Auf diese Weise kann die Vorrichtung flexibel an verschiedene Produktionsbedingungen angepasst werden, wobei gleichzeitig eine besonders zuverlässige und genaue Untersuchung der Drahtbeschichtung möglich ist.

Die erfindungsgemäße Vorrichtung weist ferner eine Drahterdung auf, welche einen leitfähigen Drahtkern des Drahts erdet, und eine Spannungserdung aufweist, welche die Voraufladungsspannungsversorgung und die Messspannungsversorgung erdet, und dass die Drahterdung und die Spannungserdung an einem gemeinsamen Massepotential angeschlossen sind. Zwar sind auch Komponenten herkömmlicher Vorrichtungen zur Untersuchung einer Drahtbeschichtung teilweise geerdet, jedoch werden dabei Erdpunkte verwendet, welche den zu erdenden Komponenten gerade am nächsten liegen. So werden Netzteile teilweise durch den Erdkontakt ihrer Stromversorgung geerdet, während andere Teile z. B. Schleifkontakte am Draht, mit einer Gehäuseerdung oder einer Erdung der Produktionsstrecke verbunden sind. In der Praxis ist es bei diesen Vorrichtungen immer wieder zu unkontrollierten und unzulässigen Ausgleichsströmen in undefinierbarer und lastabhängiger Größe zwischen den verschiedenen Erdungspunkten gekommen. Mit der erfindungsgemäßen Drahterdung bzw. Spannungserdung an einem gemeinsamen Massepotenzial wird ein definierter gemeinsamer, externer und interner Erdungspunkt geschaffen, so dass eindeutige Erdungsverhältnisse festgelegt sind und Ausgleichsströme zwischen den Erdungspunkten vermieden werden können. Es hat sich gezeigt, dass dadurch die präzise Messung von kleinen Messströmen signifikant verbessert werden kann. Um die Erdungsverhältnisse noch besser zu definieren, können ferner metallische Teile der Vorrichtung durch entsprechende Isolierungen von den strom- oder spannungstragenden Komponenten der Vorrichtung und von dem gemeinsamen Massepotenzial entkoppelt werden.

In einer kompakten und einfach zu installierenden Realisierung der Erfindung sind vorzugsweise zumindest die Messanordnung und die Messspannungsversorgung in einem gemeinsamen Basisgehäuse untergebracht und am oder im Basisgehäuse ist ferner eine Signalisierungseinrichtung vorgesehen, welche mit der Messanordnung verbunden ist, um von der Messanordnung eine Information zu empfangen, die die Erfassung eines einen Schwellwert überschreitenden Stromflusses über die Messelektrode anzeigt, wobei die Signalisierungseinrichtung auf den Empfang der Information hin ein optisches oder akustisches Meldesignal abgibt. Die Messanordnung sowie die das Messergebnis anzeigende Signalisierungseinrichtung sind in dieser Realisierung in oder an einem gemeinsamen Basisgehäuse vorgesehen, so dass sich ein einfacher und montagefreundlicher Aufbau zumindest eines Teils der Vorrichtung ergibt. Durch die Bereitstellung einer Signalisierungseinrichtung am oder im Basisgehäuse, welche ein optisches oder akustisches Meldesignal über Untersuchungsergebnisse der Drahtbeschichtung abgibt, kann das Untersuchungsergebnis in der Nähe der Produktionsanlage des Drahts, insbesondere direkt an der Verarbeitungsstrecke, für eine Bedienperson wahrnehmbar mitgeteilt werden, so dass die Bedienperson direkt vor Ort über die Qualität der Drahtbeschichtung informiert werden kann. Somit entfällt die Notwendigkeit, zur Qualitätsüberprüfung in einen entfernteren Auswertungsraum zu gehen, um beispielsweise an entsprechenden Auswertecoumputem die Messergebnisse abzufragen.

In einer besonders einfachen und wirkungsvollen Variante ist die Signalisierungseinrichtung dazu eingerichtet, das Meldesignal durch Aktivierung einer am Basisgehäuse angeordneten Warleuchte abzugeben und bei Nicht-Empfang der Information die Warnleuchte zu deaktivieren oder/und eine Normalbetriebsleuchte zu aktivieren. Eine solche Warnleuchte ist sehr einfach und kostengünstig herzustellen und bietet eine deutliche und wirkungsvolle Signalisierung eines Untersuchungsergebnisses der Drahtbeschichtung.

Alternativ oder zusätzlich kann das Basisgehäuse eine Schnittstelle zur Übertragung von Daten an eine entfernte Datenverarbeitungs- und -anzeigeeinheit aufweisen. Durch die Bereitstellung einer solchen Schnittstelle, insbesondere eines Steckkontakts oder einer Funkkommunikationsschnittstelle wird eine flexible und einfache Installation der Vorrichtung ermöglicht, und gleichzeitig die Möglichkeit einer ausführlichen Verarbeitung und Auswertung der Messergebnisse geschaffen.

Das Basisgehäuse kann ferner ein Bedienfeld zur manuellen Eingabe von Daten oder/und Befehlen sowie ein Anzeigefeld zur Anzeige von Information aufweisen, so dass ein Nutzer bestimmte Betriebsparameter oder Steuerbefehle oder dergleichen direkt am Basisgehäuse ablesen oder erkennen kann oder direkt am Basisgehäuse in die Vorrichtung eingeben kann. Solche Daten oder Befehle können der Messstrom, die Information über das Vorliegen eines Fehlers der Drahtbeschichtung, eine die Fertigungsumgebung repräsentierende Betriebsgröße (Drahtgeschwindigkeit, Beschichtungsmaterialparameter, usw.) umfassen.

Auch die Messelektrode oder/und die Voraufladungselektrode können am Basisgehäuse angebracht sein, so dass die Gesamtvorrichtung noch kompakter wird und auf zusätzliche Verdrahtung zwischen Basisgehäuse und Elektrode verzichtet werden kann.

In der erfindungsgemäßen Vorrichtung werden als Messelektrode oder/und als Voraufladungselektrode vorzugsweise Bürstenelektroden, insbesondere Kohlefaserbürstenelektroden, oder auch Rollenelektroden verwendet. Diese Elektroden können mit relativ geringen Reibungsverlusten in sicheren elektrischen Kontakt mit dem Draht gebracht werden. Als besonders zuverlässig hat sich dabei eine Realisierungsvariante herausgestellt, bei welcher die Messelektrode oder/und die Voraufladungselektrode den Draht bzw. den Drahtkern zumindest teilweise, vorzugsweise vollständig, umschließen.

In Laufrichtung des Drahts kann in einer Weiterbildung der Erfindung nach der Messelektrode eine Entladeschaltung mit einer Entladeelektrode angeordnet sein, welche in Kontakt mit der Drahtbeschichtung brinbar ist, wobei die Entladeschaltung die Entladeelektrode mit einem Massepotential verbindet, um Ladung der Drahtbeschichtung über die Entladeschaltung zum Massepotential hin abzuführen. Durch eine solche Entladeschaltung kann verhindert werden, dass Ladung oder Restladung tragender Draht einer Weiterverarbeitung, insbesondere einer Aufwicklung auf einer Aufwickeleinrichtung zugeführt wird, so dass etwa der aufgewickelte Draht keine kapazitive oder induktive Last bildet, die die empfindliche Messung von Strömen über die Messelektrode beeinflussen könnten. Um mit der Entladeschaltung eine im Wesentlichen vollständige und zuverlässige Entladung des Drahts zu erreichen, wird in einer weiteren Ausführungsform der Erfindung vorgeschlagen, dass ein der Entladeschaltung zugeordenbarer Entladewiderstand in Abhängigkeit von der Größe der Messspannung sowie von einer Laufgeschwindigkeit des Drahts so gewählt ist, dass die Drahtbeschichtung nach dem Verlassen der Entladeelektrode im Wesentlichen vollständig entladen ist.

Die Aufgabe der Erfindung wird ferner gelöst durch eine Drahtherstellungsanlage zur Herstellung eines mit einer Drahtbeschichtung versehenen Drahts, umfassend eine erfindungsgemäße Vorrichtung nach der vorstehend beschriebenen Art, ferner umfassend eine Beschichtungsstation, in welcher auf einen leitfähigen Drahtkern des Drahts die Drahtbeschichtung aufgebracht wird, eine Drahterdung, welche einen leitfähigen Drahtkern des Drahts erdet, eine Spannungserdung, welche die Voraufladungsspannungsversorgung und die Messspannungsversorgung erdet, wobei die Drahterdung in Verarbeitungsrichtung des Drahts vor der Beschichtungsstation angeordnet ist und Voraufladungselektrode sowie die Messelektrode in Verarbeitungsrichtung des Drahts nach der Beschichtungsstation angeordnet sind, und wobei die Drahterdung und die Spannungserdung an einem gemeinsamen Massepotential angeschlossen sind. Die durch eine solche Drahtherstellungsanlage erzielten Wirkungen und Vorteile entsprechen denen der vorstehend genannten Ausführungsformen der Vorrichtung, in welchen Drahterdung und Spannungserdung an einem gemeinsamen Massepotenzial angeschlossen sind. Dementsprechend kann eine definierte Erdung der Spannungsversorgungen sowie des Drahts mit einem einfachen Aufbau sichergestellt werden und die Präzision und Zuverlässigkeit der Messungen gesteigert werden.

Die Erfindung wird nachfolgend anhand eines bevorzugten Ausführungsbeispiels unter Bezugnahme auf die beigefügten Zeichnungen näher erläutert. Es zeigen:

Figur 1                 eine schematische Darstellung zur Illustration des Messprinzips für ein Ausführungsbeispiel der Erfindung,

Figur 2                 eine perspektivische Schnittansicht eines Abschnitts eines Drahts,

Figuren 3a und 3b       Beispiele für Stromkennlinien in Abhängigkeit von der Drahtgeschwindigkeit bzw. der Voraufladungsspannung, und

Figuren 4a und 4b       Beispiele für Spannungskennlinien zur Illustration der dielektrischen Relaxation.

Figur 5                 eine perspektivische Ansicht eines Hauptteils der Vorrichtung des Ausführungsbeispiels,

Figur 6                 ein Anzeige- und Bedienfeld des in Figur 3 gezeigten Hauptteils,

Figur 7                 einen schematischen Schaltplan einer in dem Hauptteil von Figur 3 untergebrachten Schaltungseinheit,

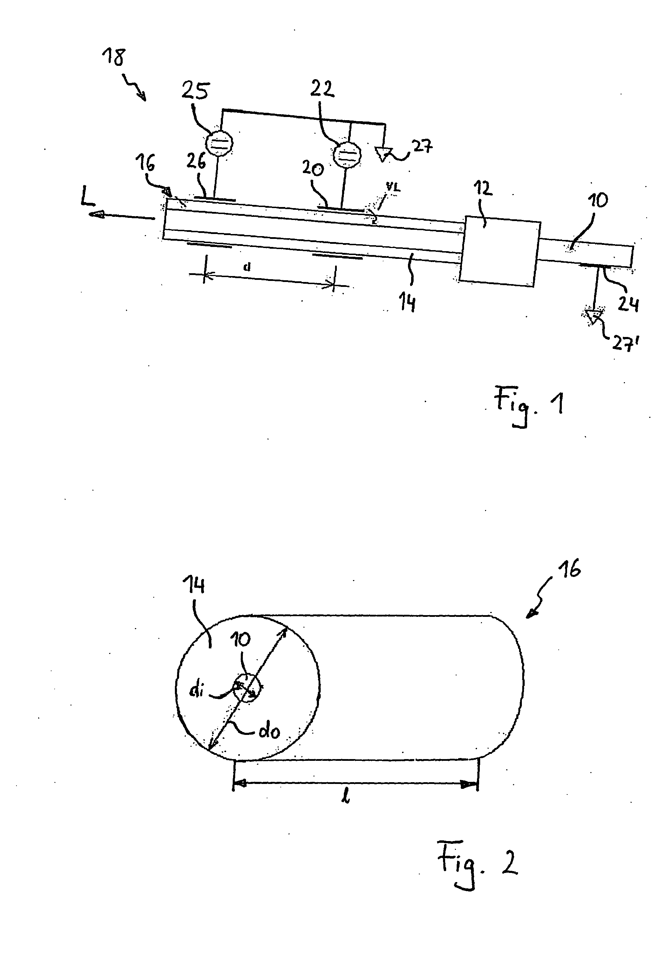

Fig. 1 illustriert das in einer nachfolgend zu beschreibenden Untersuchungsvorrichtung gemäß einem Ausführungsbeispiel der vorliegenden Erfindung verwendete Mess- bzw. Untersuchungsprinzip zur Untersuchung einer Drahtbeschichtung. In Fig. 1 wird entlang einer Laufrichtung L ein unbeschichteter, blanker Kupferrunddraht 10 einer Beschichtungsstation 12 zugeführt, in welcher auf den Kupferdraht 10 eine diesen koaxial umhüllende Beschichtung 14 aufgebracht wird. Die Beschichtung 14 umfasst mindestens eine, vorzugsweise eine Vielzahl, von Einzelschichten oder Lackierungen, die in der Beschichtungsstation 12 gleichzeitig oder nacheinander auf den Kupferdraht 10 aufgezogen werden.

Um die Qualität, insbesondere die Isolationsfestigkeit der Drahtbeschichtung 14 zu überprüfen, durchläuft der aus Kupferdraht 10 und Beschichtung 14 gebildete Draht 16 nach dem Verlassen der Beschichtungsstation 12 eine in Fig. 1 allgemein mit 18 bezeichnete Prüfstation. In Laufrichtung L des Drahts 16 umfasst die Prüfstation 18 zunächst eine Voraufladungselektrode 20, welche als Kohlefaserbürste ausgebildet ist und den Draht 16 voll umschließt, um mit möglichst großer Kontaktfläche in elektrischen Kontakt mit der Außenseite der Beschichtung 14 zu treten. Die Voraufladungselektrode 20 ist an eine Voraufladungsspannungsversorgung 22 angeschlossen, welche eine Hochspannung (Gleichspannung) an die Drahtbeschichtung 14 anlegt. In Laufrichtung L vor der Beschichtungsstation 12 ist der blanke Kupferdraht 10 durch eine Erdungselektrode 24, welche als Bürstenelektrode oder als Rollenelektrode ausgebildet sein kann, geerdet. Somit liegt die Voraufladungsspannung $V_L$ zwischen der Voraufladungselektrode 20 und dem geerdeten Kupferdraht 10 an, d. h. über der Drahtbeschichtung 14. Eine solche Anordnung stellt einen Kondensator dar, zwischen dessen Elektroden sich die Beschichtung 14 als Dielektrikum befindet. Durch das Bewegen des Drahts 16 durch die Voraufladungselektrode 20 verändert sich die Kapazität dieses Kondensators aufgrund der dielektrischen Polarisation der Drahtbeschichtung 14. Bei den für Drahtbeschichtungen üblicherweise verwendeten Materialien geht die Polarisierung auf eine Änderung der Ionen- oder Elektronenpolarisation zurück, die sich in sehr schneller Zeit ($< 10^{-13}$ sek.) aufbaut.

Wenn der Draht 16 die Voraufladungselektrode 20 wieder verlässt, so klingt die Polarisierung der Beschichtung 14 im Zeitverlauf exponentiell ab, was als dielektrische Relexation bezeichnet wird. Die Geschwindigkeit der dielektrischen Relexation, bzw. die Zeit, nach der die Polarisierung der Beschichtung 14 größtenteils ausgeglichen ist, ist abhängig von Materialparametern der Beschichtung, insbesondere der Dielektrizitätszahl $\varepsilon_r$ (dielektrische Permitivität) des verwendeten Materials sowie von der Dichte $\rho$ des Materials. Am Ort einer mit einer Messspannungsversorgung 25 verbundenen Messelektrode 26, welche in Laufrichtung L des Drahts 16 der Voraufladungselektrode 20 in einem Abstand d nachfolgt, ist somit ein Teil der Polarisation bereits abgeklungen, so dass die der Polarisation an der Messelektrode 26 entsprechende Messspannung $V_M$ niedriger ist als die Voraufladungsspannung $V_L$.

Die Messspannungsversorgung 25 und die Voraufladungsspannungsversorgung 22 sind über einen gemeinsamen Erdungspunkt 27 geerdet, welcher elektrisch identisch ist mit einem Erdungspunkt 27' der Erdungselektrode 24 des Kupferdrahts 10. Die Erdungspunkte 27 und 27' können entweder durch einen einzigen Erdungspunkt gebildet sein, indem entsprechende Kontakte der Messspannungsversorgung 25, der Voraufladungsspannungsversorgung 22 und der Erdungselektrode 24 direkt mit einem einzigen Massepunkt elektrisch verbunden sind. Alternativ könnten die Erdungspunkte 27 und 27' elektrisch gut leitend miteinander verbunden sein, etwa durch eine geerdete Kupferschiene.

Unter Bezugnahme auf Fig. 1 und 2 wird im Folgenden die Messspannung $V_M$ für den Fall einer perfekten Isolierung der Beschichtung 14 berechnet. Weiterhin wird im Folgenden angenommen, dass die Kontaktgeometrien für Voraufladungselektrode 20 und Messelektrode 26 gleich sind, nämlich durch voll umschließende Bürstenelektroden gebildet sind, welche den Draht 16 entlang einer Länge I koaxial vollständig umschließen.

Die Kapazität des in Fig. 2 gezeigten Drahts 16, genähert als koaxialer Kondensator beträgt

$$C = \varepsilon_r \varepsilon_0 \frac{2l\pi}{\ln(\frac{do}{di})} \; , \qquad\qquad (1)$$

wobei di den Durchmesser des Drahtkerns 10 und do den Gesamtdurchmesser des Drahts 16 bezeichnen.

Dementsprechend ist in dem Kondensator die Energie

$$E_s = \frac{1}{2} C V^2 \qquad\qquad (2)$$

gespeichert, wobei V der Voraufladungsspannung $V_L$ entspricht. Die gespeicherte Energie teilt sich auf in die Energie, die im Feld des Kondensators ohne Dielektrikum gespeichert ist, plus die Energie, die in Form von Polarisation im Dielektrikum gespeichert ist:

$$E_s = E_{vac} + E_{pol} \qquad (3)$$

Für die Polarisationsenergie $E_{pol}$ ergibt sich somit

$$E_{pol} = E_s - E_{vac} = \frac{1}{2}\varepsilon_r\varepsilon_0 \frac{2l\pi V^2}{\ln(\frac{do}{di})} - \frac{1}{2}\varepsilon_0 \frac{2l\pi V^2}{\ln(\frac{do}{di})} = \frac{l\pi V^2 \varepsilon_0}{\ln(\frac{do}{di})}(\varepsilon_r - 1) \qquad (4)$$

Die entsprechende Pölarisationsladung beträgt dann

$$Q_{pol} = \frac{2l\pi V_L \varepsilon_0}{\ln(\frac{do}{di})}(\varepsilon_r - 1) \qquad (5)$$

Mit dieser anfänglichen Polarisationsladung wird der Draht 16 von der Voraufladungselektrode 20 einen Abstand d unter konstanter Transportgeschwindigkeit v transportiert. Dabei findet dielektrische Relexation statt, so dass die Polarisationsladung exponentiell mit der Zeit abnimmt:

$$Q(t) = Q_{Pol}e^{(-t/\tau)} = Q_{Pol}e^{(\frac{-t}{\varepsilon_0\varepsilon_r\rho})} \qquad (6)$$

Da die Polarisationsladung proportional ist zu der durch diese hervorgerufenen Spannung, gilt entsprechend

$$V_{(t)} = V_L e^{(\frac{-t}{\varepsilon_0\varepsilon_r\rho})} \qquad (7)$$

t=d/v (v gibt die Drahtgeschwindigkeit an) folgt am Ort der Messelektrode 26 für die Messspannung $V_M$

$$V_M = V_L e^{(\frac{-d}{\varepsilon_0\varepsilon_r\rho v})} \qquad (8)$$

Die Spannung an der Messelektrode 26 ist im unbelasteten Fall somit nur abhängig von den Materialparametern p, $\varepsilon_r$, der Geschwindigkeit v des Drahts 16, dem Abstand d sowie der Voraufladungsspannung $V_L$. In der Vorrichtung des Ausführungsbeispiels der Erfindung werden diese Größen oder Parameter berücksichtigt, gesteuert/geregelt oder eingegeben.

Wenn Messspannung $V_M$ und Voraufladungsspannung $V_L$ die Beziehung der Gleichung (8) erfüllen, so fließt bei idealer Isolierung der Beschichtung 14 über die Messelektrode 26 im Wesentlichen kein Strom, da die vorhandene Polarisierung durch die Messspannung $V_M$ nicht verstärkt wird und gleichzeitig überschüssige Polarisierungsladungen auch nicht von der Beschichtung 14 auf die Messelektrode 26 fließen können. Wird die Prüfstation 18 also nach Maßgabe der vorstehenden Gleichung (8) eingestellt, so nimmt der Messstrom $I_M$ über die Messelektrode 26 zumindest einen minimalen Wert an, der eine sehr empfindliche und zuverlässige Erfassung einer Unregelmäßigkeit der Beschichtung 14 erlaubt, da bereits geringfügige Änderungen der elektrischen Eigenschaften der Drahtbeschichtung 14, insbesondere Fehlstellen oder Schwachstellen der Beschichtung 14, sofort zu einem deutlich erhöhten Messstrom $I_M$ führen, der von der Prüfstation 18 leicht erkannt werden kann und als Störung signalisiert werden kann.

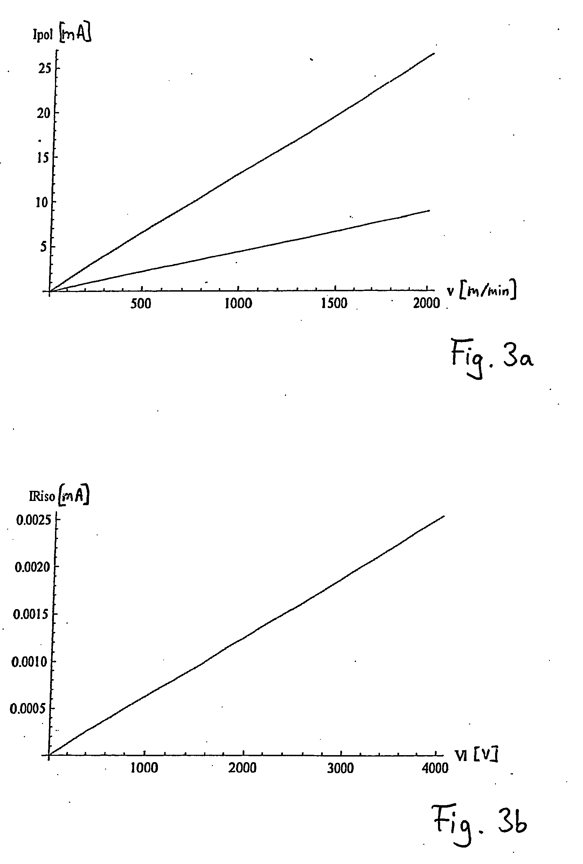

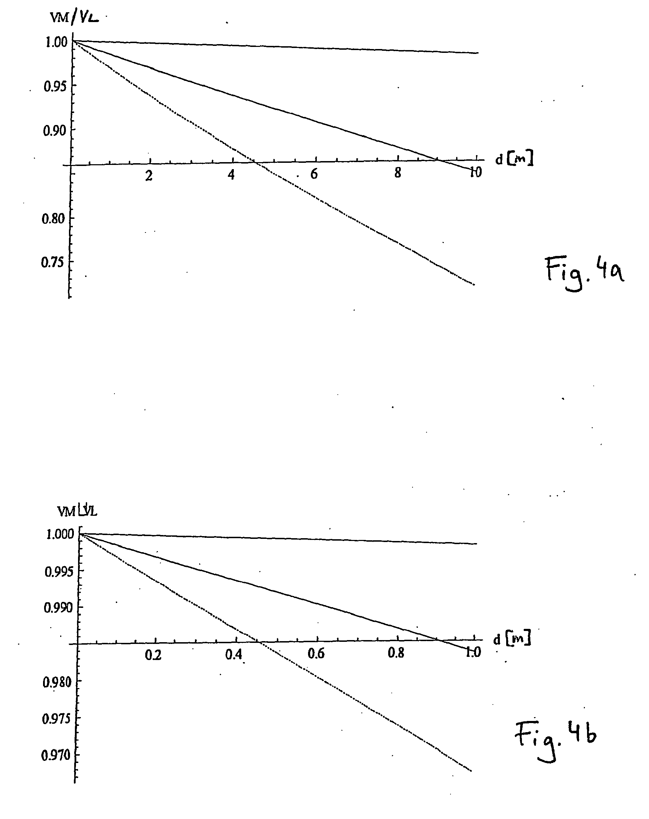

Fig. 3a, 3b sowie 4a, 4b illustrieren beispielhafte Werte für die tatsächlich fließenden Polarisierungs- oder Messströme sowie die Messspannung $V_M$ an einer Messelektrode 26. Die verwendete Beschichtung 14 weist die Materialparameter $\varepsilon_r = 3{,}4$, $\rho = 10^{12}\ \Omega m$ sowie eine Schichtdicke von $50\,\mu m$ auf. Der Durchmesser des Kupferrunddrahts beträgt $di = 0{,}35 \times 10^{-3}$ m, so dass sich für den Außendurchmesser des Drahts 16 ein Wert von $do = 0{,}45 \times 10^{-3}$ m ergibt.

Fig. 3a zeigt für die oben genannten Parameter den Verlauf des über die Voraufladungselektrode 20 fließenden Polarisationsstroms, der die kontinuierliche Polarisierung des durchlaufenden Drahts 16 gewährleistet. Mit zunehmender Geschwindigkeit v des Drahts steigt der zur Polarisierung notwendige Strom $I_{pol}$ an.

Im Vergleich dazu zeigt Fig. 3b den linearen Anstieg des tatsächlich über die Beschichtung 14 fließenden Stroms $IR_{iso}$ in Abhängigkeit von der Voraufladungsspannung $V_L$. Aus dem Vergleich der Fig. 3a und 3b ist zu erkennen, dass der für die Polarisierung der Beschichtung 14 verbrauchte Strom um etwa vier Größenordnungen größer ist als der über die Beschichtung 14 tatsächlich fließende Strom. Da der letztere Strom (über die Beschichtung 14) dem zu messenden Messstrom $I_M$ entspricht, zeigt sich an diesem Vergleich die der vorliegenden Erfindung zugrunde liegende Ausgangsproblematik, wonach die für die Messung bzw. Untersuchung der Drahtbeschichtung relevanten Messströme um mehrere Größenordnungen niedriger sind als die gleichzeitig aufgrund der kontinuierlichen Polarisierung der Beschichtung fließenden Polarisationsströme. Durch die erfindungsgemäße Kompensation und die Möglichkeit zur flexiblen Anpassung und Neukalibrierung der Prüfstation für verschiedene Fertigungsumgebungen, Fertigungsvorgaben oder Materialparameter und -geometrien des Drahts kann trotz dieser verhältnismäßig sehr geringen Messströme auch unter rauen Produktionsbedingungen ein zuverlässiges Untersuchungsergebnis erzielt werden.

Zur Bestimmung der für ein bestimmtes Beschichtungsmaterial zu verwendenden Messspannung bzw. den zu verwendenden Messstrom an der Messelektrode wird üblicherweise auf entsprechende DIN-Vorschriften zurückgegriffen. Bei einem konstanten Abstand zwischen Voraufladungselektrode und Messelektrode wird dann auf Grundlage von Tabellenwerten für eine bestimmte Laufgeschwindigkeit des Drahts eine Voraufladungsspannung als Funktion der Messspannung ausgewählt.

Fig. 4a und 4b zeigen die Abnahme des Verhältnisses zwischen Messspannung $V_M$ und Voraufladungsspannung $V_L$ bei erfindungsgemäßer Wahl von $V_M$ gemäß Gleichung (8) mit zunehmenden Abstand d zwischen Voraufladungselektrode 20 und Messelektrode 26. Zu erkennen ist, dass zwar auch nach einigen Metern die Messspannung $V_M$ noch bei etwa 90-95 % der Voraufladungsspannung liegt, berücksichtigt man jedoch den deutlichen Größenordnungsunterschied zwischen Polarisationsstrom und Messstrom (Fig. 3a und 3b) so wird erkennbar, dass bei Einstellung bzw. Kalibrierung der Prüfstation 18 nach Maßgabe der oben genannten Gleichung (8) der an der Messelektrode fließende Polarisationsstrom um mehrere Größenordnungen verringert werden kann und somit das "Signal-Rausch-Verhältnis" zwischen dem zu prüfenden Strom über die Beschichtung 14 und dem aufgrund von Polarisationsladungen über die Messelektrode fließenden Strom erhöht werden kann, um die Genauigkeit und Zuverlässigkeit der Messung zu verbessern. Wichtige Idee der Erfindung ist es, die Betriebsparameter der Prüfstation 18 entweder nach Maßgabe von Gleichung (8) oder durch Kalibrierung bzw. Selbstregelung der Prüfstation 18 so einzustellen, dass bei intakter Beschichtung 14 ein möglichst geringer Strom über die Messelektrode 26 fließt. In diesem optimale Einstellzustand der Prüfstation 18 kompensiert die Messspannung $V_M$, die an die Messelektrode 26 angelegt wird, gerade die an diesem Punkt in der Beschichtung 14 noch vorhandene Restpolarisation.

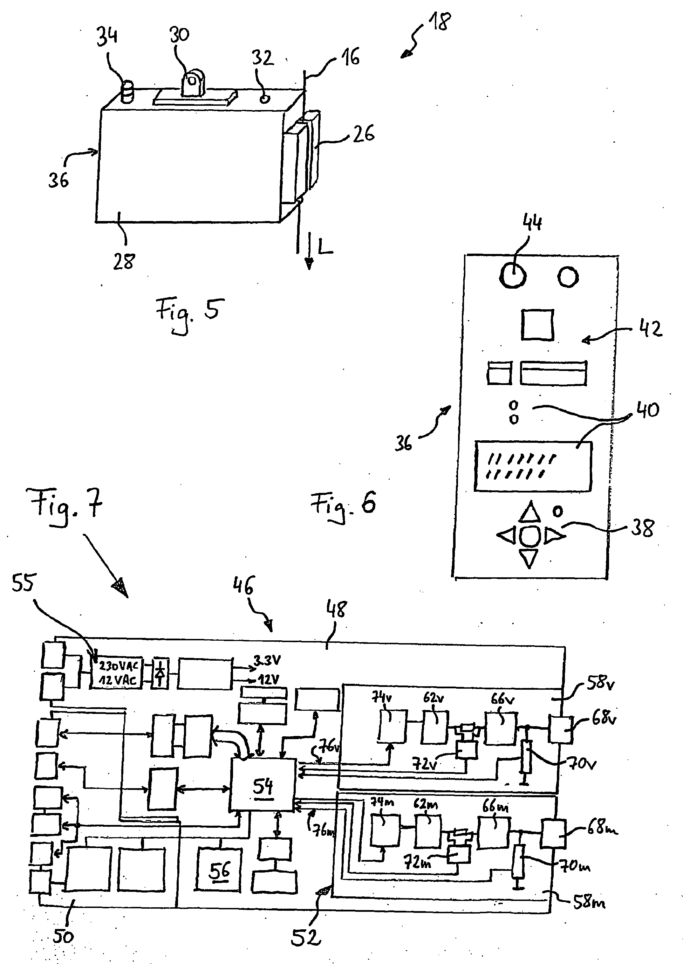

Unter Bezugnahme auf Fig. 5 bis 7 wird nachfolgend ein Hauptteil der Prüfstation 18 des Ausführungsbeispiels der Erfindung näher erläutert. Das Hauptteil umfasst ein Gehäuse 28, zum Beispiel aus Aluminium, welches aus fertigen Elementen aufgebaut ist, die aus Meterware verarbeitet und den Anforderungen entsprechend zugeschnitten werden. Eine solche Konstruktion ermöglicht die Fertigung eines individuellen Gehäuses, ohne die Kosten für eine Einzelanfertigung in Kauf nehmen zu müssen. Das fertige Gehäuse weist handliche Abmessungen auf und lässt sich über einen Befestigungsabschnitt 30 an geeigneter Stelle an der Produktionsanlage befestigen. Seitlich am Gehäuse 28 ist eine Messelektrode 26 in Form einer Kohlefaserbürstenelektrode angeordnet, so dass der Draht 16 nahe des Gehäuses 28 durch die Messelektrode 26 zu führen ist. Am Gehäuse 28 ist ferner ein Steckkontakt 32 für den Anschluss der Voraufladungselektrode 20 (in Fig. 5 nicht gezeigt) vorgesehen. Die Voraufladungselektrode 20 wird im geeigneten Abstand d von der Messelektrode 26 installiert und über ein Verbindungsdraht mit dem Steckkontakt 32 verbunden.

Am Gehäuse 28 ist ferner an gut sichtbarer Position eine Warnleuchte 34 angebracht, welche im Falle der Erfassung einer fehlerhaften Drahtbeschichtung 14 oder in einem anderen Störfall aufleuchtet und die Störung somit auffällig signalisiert. Vorteilhafterweise kann die Signalleuchte 34 gleichzeitig für die Anzeige verschiedener Störungen verwendet werden (Gerätefehler, Kommunikationsstörung, Spulenfehler oder dergleichen), so dass eine Bedienperson in diesem Falle auf das Vorhandensein einer Störung hingewiesen wird, wobei die genauere Störungsursache oder weitere Informationen zur Störung durch gesonderte Anzeigemittel oder Datenkommunikation mit einer externen Anzeigeeinrichtung wiedergegeben wird.

Der Befestigungsabschnitt 30 erlaubt die individuelle Anpassung an verschiedene Produktionsanlagen. Durch die Befestigung des Gehäuses mittels des Befestigungsabschnitts 30 wird gleichzeitig die Messelektrode 26 entsprechend dem Laufweg des Drahts 16 justiert. Alternativ oder zusätzlich kann die Messelektrode 26 in ihrer genauen Position bezüglich des Gehäuses für eine Feinjustage verlagerbar sein. In diesem Fall kann der Befestigungsabschnitt 30 relativ grob und mit guter Dauerfestigkeit ausgebildet werden, wobei für die Feineinstellung der Position der Messelektrode 26 ein zusätzlicher Einstellmechanismus vorgesehen ist. Der Befestigungsabschnitt 30 kann als Rohrbefestigung ausgebildet sein, sodass eine Ausrichtung des Gehäuses in einem Winkelbereich von bis zu ungefähr 170° möglich ist. Möglich ist ferner die Verwendung zweier 90°-Verbinder (in Fig. 5 nicht dargestellt) zur exakten Festlegung des vertikalen und des horizontalen Abstands des Gehäuses 28 zur Befestigungsebene. Bei Reduzierung der Bewegungsfreiheit des Befestigungsabschnitte 30, zum Beispiel auf höchstens 2 Bewegungsachsen, kann jedoch eine einfachere Installation des Gehäuses erreicht werden.

Fig. 6 zeigt ein Anzeige- und Bedienfeld für das Ausführungsbeispiel der erfindungsgemäßen Vorrichtung. Das Bedienfeld 36 weist fünf Tastschalter in Form eines Bedienkreuzes mit Bestätigung auf, mittels welcher Betriebsparameter manuell in die Prüfstation 18 eingegeben werden können. In Fig. 6 ist ferner ein Anzeigefeld 40 mit einer LCD-Anzeigefläche und einer Anzahl von Leuchtdioden zur Signalisierung eines Störungszustandes oder eines Normalbetriebszustands zu erkennen. Am Anzeige- und Bedienfeld 36 sind außerdem Steckkontakte 42 für den Anschluss der Prüfstation 18 an eine externe Datenverarbeitungsanlage dargestellt. Die Datenkommunikation kann auf Ethernet-Basis arbeiten.

In Fig. 6 sind mit Bezugszeichen 44 ferner Steckkontakte für den Anschluss einer Hauptspannungsversorgung (zum Beispiel zum Anschluss einer üblichen 230VAC-Netzspannung) dargestellt, über welche die Prüfstation 18 mit Energie versorgt wird. Weitere Steckkontakte für CAN und IO können ebenfalls am Anzeige- und Bedienfeld 36 bereitgestellt sein.

Fig. 7 zeigt einen schematischen Schaltplan einer Hauptschaltung 46, welche im inneren des Gehäuses 28 untergebracht ist. Die Hauptschaltung 46 umfasst eine Mikrocontrollerschaltung 48, eine Ein-/Ausgabeschaltung 50 sowie eine Hochspannungsschaltung 52.

Die Mikrocontrollerschaltung 48 ist für die Überwachung der Hochspannungen sowie der Datenverarbeitung der mit der Ein-/Ausgabeschaltung 50 ausgetauschten Daten verantwortlich und umfasst einen Mikrocontroller 54 (ARM-7-Controller). Die Datenverarbeitung der Messwerte erfolgt im Mikrocontroller 54 interruptgesteuert. Die Timer- und Messinterrupts werden mit höchster Priorität verarbeitet, um eine kontinuierliche Erfassung der Messwerte sicherzustellen. Auf der Mikrocontrollerschaltung 48 ist ferner ein Spannungswandler 55 mit einem Transformator und einem Gleichrichter zur Umwandlung der 230V-Netzspannung (Wechselspannung) in eine Rohspannung von 14V-Gleichspannung vorgesehen. Der Mikrocontroller wird durch einen Spannungsmonitor mit integriertem Watchdog und RTC überwacht. Zur Speicherung von Messdaten wird ein Flash-Speicher 56 verwendet, welcher auch bei Stromausfall einen Erhalt der notwendigen Daten gewährleistet.

Der Mikrocontroller 54 übernimmt ferner eine Überwachungsfunktion zur Überwachung der Voraufladungsspannung sowie der Messspannung. Wenn Abweichungen von den Sollgrößen festgestellt werden, so führt der Mikrocontroller eine automatische Nachregelung einer der beiden Hochspannungen aus, so dass eine zeitlich stabile Relativbeziehung zwischen Voraufladungsspannung und Messspannung aufrechterhalten bleibt.

Die Ein-/Ausgabeschaltung 50 umfasst eine Mehrzahl von Steckkontakten zum Anschluss externer Dateneingabegeräte, Datenauswertungsgeräte und dergleichen. Insbesondere ist das Anzeige- und Bedienfeld 36 mit seinen zugeordneten Datenübertragungsanschlüssen an der Ein-/Ausgabeschaltung 50 angeschlossen. Ferner besteht die Möglichkeit, per Steckverbinder einen Geschwindigkeitssensor anzuschließen, der die tatsächliche Laufgeschwindigkeit des Drahts 16 erfasst und der Prüfstation 18 als Betriebsparameter bereitstellt. Die Laufgeschwindigkeit des Drahts kann etwa 2000 m/min betragen.

Die Hochspannungsschaltung 52 umfasst zwei voneinander separat bereitgestellte und galvanisch getrennte (entkoppelte) Hochspannungseinheiten, eine Voraufladungseinheit 58v und eine Messeinheit 58m. In jeder der Hochspannungseinheiten 58v, 58m wird die vom Spannungswandler 55 ausgegebene Rohspannung von 14V auf eine Hochspannung transformiert, wofür jede Hochspannungseinheit 58v, 58m einen eigenen Transformator 62v, 62m aufweist. In einer anschließenden Hochspannungskaskade 66v, 66m wird die Spannung schließlich auf die Sollspannung erhöht.

Zur Regelung der Hochspannung weist jede der Hochspannungseinheiten 58v, 58m einen Spannungsteiler 70v, 70m auf, der einen Teil der Hochspannung abgreift und zur Mikrocontrollerschaltung 48 zurückführt. Die Voraufladungsspannung wird schließlich am Steckkontakt 68v (32) bereitgestellt, an welchen die Voraufladungselektrode 20 angeschlossen ist, während die Messspannung über den Ausgang 68m an die direkt am Gehäuse vorgesehene Messelektrode 26 abgegeben wird.

Zur Messung des Stroms, der über die Voraufladungselektrode 20 bzw. über die Messelektrode 26 fließt, ist in jeder der Hochspannungseinheiten 58v, 58m jeweils ein Strommessgerät 72v, 72m bereitgestellt, welches den der Hochspannungskaskade 66v, 66m zugeführten Strom misst. Dieser Strom repräsentiert mit ausreichend geringer zeitlicher Verzögerung den tatsächlich über die Elektroden fließenden Strom. Für jede der Hochspannungseinheiten 58v, 58m ist ferner eine eigene Hochspannungsvorregelung 74v, 74m vorgesehen, welche die der Primärseite der Transformatoren 62v, 62m zugeführte Spannung entsprechend der Steuer-/Regelanweisungen der Mikrocontrollerschaltung 48 steuert/regelt.

Die Hochspannungsvorregelung 74v, das Strommessgerät 72v sowie der Spannungsteiler 70v der Voraufladungseinheit 58v sind jeweils über eigene Verbindungsleitungen 76v mit dem Mikrocontroller 54 verbunden. Ebenso sind der Hochspannungsvorregler 74m, das Strommessgerät 72m sowie der Spannungsteiler 70m der Messeinheit 58m jeweils über separate Verbindungsleitungen 76m mit dem Mikrocontroller 54 verbunden. Im Ausführungsbeispiel verlaufen somit zwischen den Hochspannungseinheit 58v, 58m und dem Mikrocontroller 54 insgesamt mindestens sechs Verbindungsleitungen 76v, 76m.

Der Mikrocontroller 54 gibt für jede Hochspannungseinheit 58v, 58m einen separaten Sollwert vor und schaltet die Hochspannung an den Ausgängen 68v, 68m aus und ein. Ferner überwacht er kontinuierlich (z.B. mit ungefähr 2,6 Kilosamples/Sekunden) den von den Spannungsmessgeräten 72v, 72m gemessenen Strom. Durch die Rückführung des gemessenen Stroms sowie die Rückführung eines Signals der Spannungsteiler 70v, 70m zum Mikrocontroller 54 erfolgt ferner eine analoge Regelung jeder der beiden einzustellenden Hochspannungen auf den gewünschten Sollwert.

In Fig. 7 nicht dargestellt ist eine Strombegrenzungsschaltung, die den Stromfluss über die Messelektrode 26 beispielsweise auf ungefähr $50\mu A$, begrenzt. Zur Erhöhung der Präzision der Messung sowie der Zuverlässigkeit der Untersuchung sind beide Hochspannungseinheiten 58v, 58m in Bezug auf die verwendeten Bauteile und sonstige Schaltungscharakteristiken im Wesentlichen identisch ausgebildet. Wichtige Komponenten können redundant ausgelegt werden, um Fehler rechtzeitig zu erkennen und fehlerhafte Prüfungsergebnisse, insbesondere das Ausbleiben einer Signalisierung trotz des Auftretens einer fehlerhaften Beschichtung 14, zu vermeiden.

Auf der Hauptschaltung 46 ist für den Betrieb des Mikrocontrollers 54 ein Ablaufprogramm installiert, welches als Hardware oder Software gespeichert ist bzw. geladen wird. Aufgabe dieses Ablaufprogramms ist die Steuerung des Betriebs zur kontinuierlichen Erfassung der über die Elektroden fließenden Ströme, zur Signalisierung von Fehlern oder Störungen sowie zur Bewältigung des Datenaustauschs über die Schnittstellen (Ethernet/CAN/USB). Ferner steuert das Ablaufprogramm die Ein- und Ausgabe über das Anzeige- und Bedienfeld sowie über sonstige Steckkontakte oder Anschlüsse des Hauptteils oder der Prüfstation 18 insgesamt. Das Ablaufprogramm kann aus einer Störung sowie zusätzlicher Informationen über Datum, Uhrzeit, laufende Position des Drahts 16 usw., die Position des fehlerhaften Abschnitts des Drahts 16 abspeichern, anzeigen und übertragen.

Im Folgenden wird ein Betrieb der Prüfstation 18 zur Kalibrierung der Prüfstation sowie während des Messbetriebs erläutert.

Zur Installation der Prüfstation 18 wird das Gehäuse 28 an geeigneter Position an der Produktionsanlage befestigt und die Position der Messelektrode 26 wird an den Laufweg des Drahts 16 angepasst. In einem Abstand d von der Messelektrode 26 in zur Laufrichtung L des Drahts 16 entgegengesetzter Richtung (also zwischen Messelektrode 26 und Beschichtungsstation 12) wird die Voraufladungselektrode 20 installiert, sodass der Draht 16 durch diese hindurch läuft.

An einer Position vor der Beschichtungsstation 12, an der der Kupferdraht 10 noch keine Beschichtung trägt, wird ein Erdleiter 24 in Kontakt mit dem Kupferdraht 10 gebracht. Der Erdleiter 24 wird am gleichen Massepotential angeschlossen wie ein Erdleiter der Hauptschaltung 46, welcher der gemeinsame Erdleiter für Voraufladungsspannungsversorgung und Messspannungsversorgung ist. Durch Anschluss an ein- und demselben Erdungspunkt oder durch elektrisch leitfähige Verbindung zwischen zwei separaten Erdungspunkten wird sichergestellt, dass sowohl die Spannungsversorgungen für Voraufladungsspannung und Messspannung als auch der Kupferdraht 10 auf einem definierten, gemeinsamen Massepotential liegen.

Zur Kalibrierung der Prüfstation werden ferner in die Hauptschaltung 46 die Betriebsparameter der Prüfstation 18 bzw. der Produktionsanlage eingegeben. Die Eingabe erfolgt entweder über eine entfernte Datenverarbeitungsanlage, welche über die genannten Schnittstellen mit dem Hauptteil verbunden sind, über manuelle Dateneingabe mittels des Anzeige- und Bedienfeldes 36 oder über die entsprechende Bereitstellung von gespeicherten Werten, z.B. im Flash-Speicher 56. Als Betriebsparameter werden im illustrierten Ausführungsbeispiel zumindest der Abstand d zwischen Voraufladungselektrode 20 und Messelektrode 26, die Geschwindigkeit v des Drahts 16 beim Transport von Voraufladungelektrode 20 zu Messelektrode 26, Parameter zur Charakterisierung des Drahts 16 (Durchmesser di des Kupferdrahts 10, Schichtdicke der Beschichtung 14, sonstige Geometriefaktoren des Drahts, dielektrische Permittivität des Beschichtungsmaterials oder diese Größen repräsentierende Werte) eingegeben. Die genannten Betriebsparameter müssen nicht tatsächlich als einzelne Größen eingegeben werden, stattdessen können ein oder mehrere Parameter oder Kennzahlen eingegeben werden, die Informationen über diese Betriebsparameter enthalten. Denkbar ist auch die Abspeicherung von Sätzen von Betriebsparametern in einem Speicher der Hauptschaltung 46, so dass bei der Installation der Prüfstation 18 lediglich ein Typ der Produktionsanlage aus einer Mehrzahl vordefinierter Typen ausgewählt werden muss. Unter dem allgemeinen Merkmal der "Eingabe von Betriebsparametern", wie es in der vorliegenden Offenbarung verwendet wird, ist jede Bereitstellung von Information an die Hauptschaltung 46 aufzufassen, welche Information über die Produktions- und Messumgebung enthält.

Als nächstes wird die Größe der Messspannung $V_M$ festgelegt. Im einfachsten Fall kann aus den bekannten Betriebsparametern unter Verwendung von Gleichung (8) eine geeignete Messspannung $V_M$ ermittelt werden. Vorzugsweise wird ein genauer Wert für $V_M$ jedoch durch eine Kalibrierung der Prüfstation im laufenden Betrieb der Produktionsanlage oder zumindest im Testlauf während der Durchführung eines Drahts 16 durch die Elektroden 20, 26 ausgeführt. Dazu wird der Draht 16 durch die Elektroden 20, 26 mit der Geschwindigkeit v hindurch geführt, eine gewünschte Voraufladungsspannung wird an die Voraufladungselektrode 20 angelegt und eine Messspannung $V_M$ im geeigneten Bereich (beispielsweise entsprechend Gleichung (8)) wird an die Messelektrode 26 angelegt. Für die Kalibrierung der Prüfstation 18 gibt es dann mehrere Möglichkeiten: In einer ersten Möglichkeit wird die Spannung $V_M$ an der Messelektrode 26 variiert und gleichzeitig die Größe des Messstroms über das Strommessgerät 72m überwacht. Die Messspannung $V_M$ wird solange verändert, bis der Messstrom über die Messelektrode ein Minimum erreicht. In einer zweiten Möglichkeit wird der Abstand d zwischen Messelektrode 26 und Voraufladungselektrode 20 verändert, bis der Messstrom über die Messelektrode 26 ein Minimum erreicht. In einer dritten Möglichkeit kann auch die Größe der Voraufladungsspannung verändert werden, bis ein minimaler Wert für den Messstrom über die Messelektrode 26 erreicht wird.

Prinzipiell besteht auch die Möglichkeit, zur Kalibrierung der Prüfstation 18 andere die Restpolariation der Beschichtung 14 beeinflussende Parameter zu variieren, um ein Minimum des Messstroms zu erreichen. So wäre etwa eine Variierung der Geschwindigkeit v des Drahts denkbar. Dies ist jedoch in der Praxis mit dem Nachteil verbunden, dass in den Produktionsprozess eingegriffen wird, der anderen Optimierungskriterien unterliegt.

Nach der Kalibrierung kann die eigentliche Herstellung des Drahts 16 bei gleichzeitiger Überwachung bzw. Untersuchung der Qualität der Drahtbeschichtung 14 stattfinden. Der kontinuierlich aus der Beschichtungsstation 12 austretende Draht 16 durchläuft die Prüfstation 18, wobei fortlaufend der über die Messelektrode 26 fließende Strom überwacht wird. Bei erfolgreicher Kalibrierung und intakter Drahtbeschichtung 14 ist dieser Strom relativ klein und kann im Bereich weniger μA liegen. Ein solcher ordungsgemäßer Betrieb wird am Gehäuse 28 der Prüfstation 18 bestätigt, zum Beispiel durch Leuchten einer Normalbetriebsleuchte (z.B. grün).

Wenn ein Abschnitt mit fehlerhafter Drahtbeschichtung 14 die Prüfstation passiert, so wird das Gleichgewicht zwischen Polarisierung und dielektrischer Realaxation gestört. Zusätzlich kommt es nunmehr zu einem deutlichen Stromfluss über die defekte Drahtbeschichtung hinweg zwischen den unter Hochspannung stehenden Elektroden 20 bzw. 26 und dem Kupferdraht 10. In der Folge tritt ein deutlicher Anstieg des Stroms über die Messelektrode 26 auf, der von der Hauptschaltung 46 als Fehler registriert wird und über die Signalleuchte 34 (z. B. rot) für die Bedienperson vor Ort deutlich angezeigt wird. Darüber hinaus registriert die Hauptschaltung 46 weitere Daten bezüglich des auftretenden Fehlers zur späteren Auswertung. Die Bedienperson kann nun vor Ort sofort auf die Störung reagieren, um den beschädigten Abschnitt des Drahts zu entfernen bzw. entsprechend zu markieren. Ferner kann die Ursache der fehlerhaften Drahtbeschichtung z. B. eine Störung der Beschichtungsstation 12 schnell erkannt werden. Darüber hinaus kann die Störungssignalisierung auch im Falle einer sonstigen Störung z. B. eines Defekts der Prüfstation 18 an sich, erfolgen, um die Bedienperson vor Ort auf die Fehlfunktion hinzuweisen.

In einer alternativen Variante der Prüfstation 18 kann das Gehäuse 28, zumindest jedoch eine Signalisierungseinrichtung der Prüfstation 18 direkt an einer in Laufrichtung L der Prüfstation 18 nachfolgenden Drahtrolle (in den Figuren nicht gezeigt) angebracht sein. Im Falle des Auftretens einer Störung in Form einer defekten Drahtbeschichtung kann die Störung dann direkt an der Drahtrolle angezeigt werden, so dass eine Bedienperson spätestens beim Austausch der fertig aufgewickelten Drahtrolle durch eine leere Rolle auf die Störung aufmerksam wird und die fehlerhafte Drahtrolle aussondern kann. So wird auch bei nicht-kontinuierlicher personeller Überwachung der Produktionsanlage sichergestellt, dass keine fertige Drahtrolle mit einem fehlerhaften Drahtabschnitt weiterverarbeitet bzw. ausgeliefert wird.

Als vorteilhaft hat sich ferner herausgestellt, die Prüfstation mit einem zusätzlichen allgemeinen Eingang für die Eingabe von Signalen betreffend eine Maschinenstörung auszustatten, welcher eine Abspeicherung von Fehlzuständen der Maschine in Bezug auf die Messposition sowie eine Berücksichtigung solcher Informationen bei der oben beschriebenen Prüfung der Drahtbeschichtung ermöglicht.

Zur weiteren Verbesserung der Genauigkeit und Zuverlässigkeit der Messergebnisse sollte darauf geachtet werden, dass das Ripple der Voraufladungsspannung sowie der Messspannung ausreichend klein ist und der Drift beider Spannungen gleichsinnig bzw. vernachlässigbar klein ist.

In den Zeichnungen nicht dargestellt ist eine Entladeschaltung, über welche überschüssige Ladung des Drahts 16 nach dem Durchlaufenden der Prüfstation 18 zur Erde hin abgeführt werden kann. Eine solche Entladeschaltung kann vorteilhaft eingesetzt werden, um einen möglichst ladungsfreien Zustand des aufgewickelten, fertigen Drahts zu schaffen. Die Entladeschaltung kann im einfachsten Fall einen Entladewiderstand aufweisen, über welchen die Ladung des Drahts zur Erde hin abgeführt wird. Eine zweckmäßige Größe des Entladewiderstand einer solchen Entladeschaltung kann wie folgt ermittelt werden: mit Gleichung (4) und der allgemein bekannten Beziehung:

$$P_{ent} = E_{pol}/t = E_{pol}\, v/l \qquad\qquad (9)$$

wobei l die Elektrodenlänge angibt, ergibt sich:

$$P_{ent} = \frac{\pi V^2 \varepsilon_0 (\varepsilon_r - 1) e^{\left(\frac{-2d_{LE}}{\varepsilon_0 \varepsilon_r p \upsilon}\right)}}{\ln(\frac{do}{di})} \upsilon \qquad\qquad (10)$$

Die Entladezeitkonstante der Entladeschaltung wird bestimmt von der Kapazität $C_M$ des Messkontakts 26 sowie dem externen Lastwiderstand $R_{ext}$:

$$\tau_{ent} = R_{ext} C_M = R_{ext} \frac{2l\pi\varepsilon_0 \varepsilon_r}{\ln(do / di)} \qquad\qquad (11)$$

Um eine vollständige Entladung zu gewährleisten wird angesetzt: $3\tau_{ent} < t_{Kontakt}$, wobei die Kontaktzeit $t_{Kontakt}$ durch $t_{Kontakt}$ = l/v gegeben ist (l = Länge des Entladekontakts, v = Geschwindigkeit des Drahts). Somit ergibt sich als Maximalwert für den Entladewiderstand der Entladeschaltung:

$$R_{ext} = \frac{\ln(do / di)}{6\pi\varepsilon_0 \varepsilon_r \upsilon} \qquad\qquad (12)$$

Wird für den der Entladeschaltung zuordenbaren Entladewiderstand ein Wert verwendet, der kleiner oder ungefähr gleich dem Wert $R_{ext}$ ist, so kann im Wesentlichen jegliche Restpolarisierung des Drahts beim Durchlaufen der Entladeschaltung zur Erde hin abgeführt werden, so dass ein im Wesentlichen ladungs- bzw. polarisationsfreier Draht weiterverarbeitet, insbesondere auf eine Aufwicklung aufgerollt wird.

**Patentansprüche**

1. Vorrichtung (18) zur Untersuchung einer Drahtbeschichtung (14) eines entlang einer Laufrichtung (L) bewegten Drahts (16), wobei die Vorrichtung (18) umfasst:

   - eine Voraufladungselektrode (20), welche an einer Voraufladungsposition mit einer Drahtbeschichtung (14) eines Drahts (16) in elektrischen Kontakt bringbar ist,
   - eine Voraufladungsspannungsversorgung (58v), welche mit der Voraufladungselektrode (20) verbunden ist, um eine Voraufladungsspannung an die Drahtbeschichtung (14) anzulegen,
   - eine Messelektrode (26), welche an einer in Laufrichtung des Drahts (16) der Voraufladungsposition in einem

13

Abstand (d) nachfolgenden Messposition mit der Drahtbeschichtung (14) des Drahts (16) in elektrischen Kontakt bringbar ist,
- eine Messspannungsversorgung (58m), welche mit der Messelektrode (26) verbunden ist, um eine Messspannung an die Drahtbeschichtung (14) anzulegen, und
- eine Messanordnung (72m), welche für die Erfassung eines Stromflusses über die Messelektrode (26) eingerichtet ist,
wobei die Voraufladungsspannungsversorgung (58v) und die Messspannungsversorgung (58m) voneinander galvanisch getrennte Spannungsausgänge (68v, 68m) aufweisen, und wobei die Vorrichtung (18) ferner eine Drahterdung (24) aufweist, welche einen leitfähigen Drahtkern (10) des Drahts (16) erdet, und eine Spannungserdung (25) aufweist, welche die Voraufladungsspannungsversorgung (58v) und die Messspannungsversorgung (58m) erdet
**dadurch gekennzeichnet, dass** die Voraufladungsspannungsversorgung (58v) und die Messspannungsversorgung (58m) über eine Überwachungsschaltung (48) miteinander gekoppelt sind, welche für einen Vergleich zwischen der Voraufladungsspannung und der Messspannung oder zwischen diese Spannungen repräsentierenden Größen eingerichtet ist,
dass die Vorrichtung (18) eine Fehlerdiagnoseeinrichtung (48) umfasst, welche dazu eingerichtet ist, auf Grundlage einer Spannung oder eines Stroms über die Voraufladungselektrode (20) oder/und auf Grundlage einer Spannung oder eines Stroms über die Messelektrode (26) einen Fehlerzustand in der Vorrichtung (18) zu erfassen,
, und
dass die Drahterdung (24) und die Spannungserdung (25) an einem gemeinsamen Massepotential angeschlossen sind.

2.  Vorrichtung (18) nach Anspruch 1, **dadurch gekennzeichnet, dass** die Voraufladungsspannungsversorgung (58v) zur Einstellung unterschiedlicher Voraufladungsspannungen verstellbar ist oder/und die Messspannungsversorgung (58m) zur Einstellung unterschiedlicher Messspannungen verstellbar ist.

3.  Vorrichtung (18) nach Anspruch 1 oder Anspruch 2, **gekennzeichnet durch** eine Positionierungseinrichtung zur Verstellung des Abstands zwischen Voraufladungselektrode (20) und Messelektrode (26).

4.  Vorrichtung (18) nach einem der vorhergehenden Ansprüche, **gekennzeichnet durch** eine Steuer-/Regeleinrichtung (54, 48), welche einen Eingang für die Eingabe einer Betriebsgröße aufweist, wobei die Steuer-/Regeleinrichtung (54, 48) dazu eingerichtet ist, die Voraufladungsspannung oder/und die Messspannung oder/und den Abstand (d) zwischen Voraufladungselektrode (20) und Messelektrode (26) in Abhängigkeit von der mindestens einen eingegebenen Betriebsgröße einzustellen, wobei die Betriebsgröße vorzugsweise ausgewählt ist aus: Voraufladungsspannung, Messspannung, Abstand (d) zwischen Voraufladungselektrode (20) und Messelektrode (26), Geschwindigkeit (v) des Drahts (16) in Laufrichtung (L) und Parameter zur Charakterisierung des Drahts.

5.  Vorrichtung (18) nach Anspruch 4, **dadurch gekennzeichnet, dass** die Überwachungsschaltung (48) dazu eingerichtet ist, ein Vergleichsergebnis des Vergleichs an die Steuer-/Regeleinrichtung (54, 48) auszugeben, und
dass die Steuer-/Regeleinrichtung (54, 48) dazu eingerichtet ist, die Voraufladungsspannung oder/und die Messspannung oder/und den Abstand zwischen Voraufladungselektrode (20) und Messelektrode (26) in Abhängigkeit von dem Vergleichsergebnis zu steuern/zu regeln.

6.  Vorrichtung (18) nach einem der vorhergehenden Ansprüche und nach Anspruch 4, **dadurch gekennzeichnet, dass** die Messanordnung (72m) dazu eingerichtet ist, den erfassten Messelektrodenstromfluss an die Steuer-/Regeleinrichtung (54, 48) auszugeben, und
**dass** die Steuer-/Regeleinrichtung (54, 48) dazu eingerichtet ist, die Voraufladungsspannung oder/und die Messspannung oder/und den Abstand zwischen Voraufladungselektrode (20) und Messelektrode (26) in Abhängigkeit von dem Messelektrodenstromfluss zu steuern/zu regeln.

7.  Vorrichtung (18) nach einem der vorhergehenden Ansprüche und nach Anspruch 4, **dadurch gekennzeichnet, dass** die Steuer-/Regeleinrichtung (54, 48) dazu eingerichtet ist, die Voraufladungsspannung oder/und die Messspannung oder/und den Abstand zwischen Voraufladungselektrode (20) und Messelektrode (26) so einzustellen, dass im Falle einer ordnungsgemäßen Drahtbeschichtung (14) ein minimaler Strom oder kein Strom über die Messelektrode (26) fließt.

8.  Vorrichtung (18) nach einem der vorhergehenden Ansprüche, **dadurch gekennzeichnet, dass** zumindest die Messanordnung (72m, 54) und die Messspannungsversorgung (58m) in einem gemeinsamen Basisgehäuse (28) untergebracht sind und dass am oder im Basisgehäuse (28) ferner eine Signalisierungseinrichtung (34, 36) vorgesehen ist, welche mit der Messanordnung (72m, 54) verbunden ist, um von der Messanordnung (72m, 54) eine Information zu empfangen, die die Erfassung eines einen Schwellwert überschreitenden Stromflusses über die Messelektrode (26) anzeigt, und wobei die Signalisierungseinrichtung (34, 36) dazu eingerichtet ist, auf den Empfang der Information hin ein optisches oder akustisches Meldesignal abzugeben, wobei die Signalisierungseinrichtung (34, 36) vorzugsweise dazu eingerichtet ist, das Meldesignal durch Aktivierung einer am Basisgehäuse angeordneten Warnleuchte (34) abzugeben und bei Nicht-Empfang der Information die Warnleuchte (34) zu deaktivieren oder/und eine Normalbetriebsleuchte zu aktivieren.

9. Vorrichtung (18) nach Anspruch 8, **dadurch gekennzeichnet, dass** das Basisgehäuse (28) eine Schnittstelle (42) zur Übertragung von Daten an eine entfernte Datenverarbeitungs- und -anzeigeeinheit aufweist, oder/und

dass das Basisgehäuse (28) ein Bedienfeld (36) zur manuellen Eingabe von Daten oder/und Befehlen sowie ein Anzeigefeld (36) zur Anzeige von Information aufweist, oder/und

dass die Messelektrode (26) oder/und die Voraufladungselektrode am Basisgehäuse (28) angebracht ist/sind.

10. Vorrichtung (18) nach einem der vorhergehenden Ansprüche, **dadurch gekennzeichnet, dass** die Messelektrode (26) oder/und die Voraufladungselektrode (20) oder/und eine/die Drahterdung (24) der Vorrichtung (18) dafür eingerichtet ist/sind, einen Draht (16) bzw. Drahtkern (10) zumindest teilweise zu umschließen.

11. Vorrichtung (18) nach einem der vorhergehenden Ansprüche, **gekennzeichnet durch** eine Entladeschaltung mit einer Entladeelektrode, welche in Laufrichtung des Drahts (16) nach der Messelektrode (26) angeordnet und in Kontakt mit der Drahtbeschichtung (14) bringbar ist, wobei die Entladeschaltung die Entladeelektrode mit einem Massepotential verbindet, um Ladung des Drahts (16) zum Massepotential hin abzuführen, wobei vorzugsweise ein der Entladeschaltung zuordenbarer Entladewiderstand in Abhängigkeit von der Größe der Messspannung sowie von einer Laufgeschwindigkeit des Drahts (16) so gewählt ist, dass die Drahtbeschichtung (14) nach dem Verlassen der Entladeelektrode vollständig entladen ist.

12. Drahtherstellungsanlage zur Herstellung eines mit einer Drahtbeschichtung (14) versehenen Drahts (16), umfassend:

- eine Vorrichtung (18) zur Untersuchung der Drahtbeschichtung (14) nach einem der vorhergehenden Ansprüche,
- eine Beschichtungsstation (12), in welcher auf einen leitfähigen Drahtkern (10) des Drahts (16) die Drahtbeschichtung (14) aufgebracht wird,
- eine Drahterdung (24), welche einen leitfähigen Drahtkern (10) des Drahts (16) erdet,
- eine Spannungserdung (25), welche die Voraufladungsspannungsversorgung (58v) und die Messspannungsversorgung (58m) erdet,

wobei die Drahterdung (24) in Verarbeitungsrichtung des Drahts vor der Beschichtungsstation (12) angeordnet ist und die Voraufladungselektrode (20) sowie die Messelektrode (26) in Verarbeitungsrichtung des Drahts (16) nach der Beschichtungsstation (12) angeordnet sind, und

wobei die Drahterdung (24) und die Spannungserdung (25) an einem gemeinsamen Massepotential angeschlossen sind.

**Claims**

1. Device (18) for inspecting a wire coating (14) of a wire (16) which is moved in a flow direction (L), the device (18) comprising:

- a precharge electrode (20) which can be brought into electrical contact with a wire coating (14) of a wire (16) at a precharge position,
- a precharge voltage supply (58v) which is connected to the precharge electrode (20) in order to apply a precharge voltage to the wire coating (14),
- a measuring electrode (26) which can be brought into electrical contact with the wire coating (14) of the wire (16) at a measuring position downstream from the precharge position by a distance (d) in a flow direction of the wire (16),
- a measuring voltage supply (58m) which is connected to the measuring electrode (26) in order to apply a measuring voltage to the wire coating (14), and

- a measuring assembly (72m) which is designed to detect a current flow across the measuring electrode (26), the precharge voltage supply (58v) and the measuring voltage supply (58m) having voltage outputs (68v, 68m) which are galvanically isolated from one another, the device (18) further having an wire earthing (24) which earths a conductive wire core (10) of the wire (16) and having an voltage earthing (25) which earths the precharge voltage supply (58v) and the measuring voltage supply (58m), **characterised in that** the precharge voltage supply (58v) and the measuring voltage supply (58m) are coupled together via a monitoring circuit (48) which is designed to compare the precharge voltage and the measuring voltage or values representing these voltages, **in that** the device (18) comprises an error diagnosis device (48) which is designed to detect an error in the device (18) on the basis of a voltage or a current across the precharge electrode (20) and/or on the basis of a voltage or a current across the measuring electrode (26), and **in that** the wire earthing (24) and the voltage earthing (25) are connected to a common earth potential.

2. Device (18) according to claim 1, **characterised in that** the precharge voltage supply (58v) can be adjusted in order to set different precharge voltages, and/or the measuring voltage supply (58m) can be adjusted in order to set different measuring voltages.

3. Device (18) according to either claim 1 or claim 2, **characterised by** a positioning device for adjusting the distance between the precharge electrode (20) and the measuring electrode (26).

4. Device (18) according to any one of the preceding claims, **characterised by** a control/regulating device (54, 48) which comprises an input for inputting an operating variable, the control/regulating device (54, 48) being designed to adjust the precharge voltage and/or the measuring voltage and/or the distance (d) between the precharge electrode (20) and the measuring electrode (26) as a function of the at least one input operating variable, the operating variable preferably being selected from: precharge voltage, measuring voltage, distance (d) between the precharge electrode (20) and the measuring electrode (26), speed (v) of the wire (16) in the flow direction (L), and parameters for characterising the wire.

5. Device (18) according to claim 4, **characterised in that** the monitoring circuit (48) is designed to output a result of the comparison to the control/regulating device (54, 48), and **in that** the control/regulating device (54, 48) is designed to control/regulate the precharge voltage and/or the measuring voltage and/or the distance between the precharge electrode (20) and the measuring electrode (26) as a function of the result of the comparison.

6. Device (18) according to any one of the preceding claims and according to claim 4, **characterised in that** the measuring assembly (72m) is designed to output the detected measuring electrode current flow to the control/regulating device (54, 48), and **in that** the control/regulating device (54, 48) is designed to control/regulate the precharge voltage and/or the measuring voltage and/or the distance between the precharge electrode (20) and the measuring electrode (26) as a function of the measuring electrode current flow.

7. Device (18) to any one of the preceding claims and according to claim 4, **characterised in that** the control/regulating device (54, 48) is designed to adjust the precharge voltage and/or the measuring voltage and/or the distance between the precharge electrode (20) and the measuring electrode (26) in such a way that a minimal current or no current flows across the measuring electrode (26) if the wire coating (14) is properly formed.

8. Device (18) according to any one of the preceding claims, **characterised in that** at least the measuring assembly (72m, 54) and the measuring voltage supply (58m) are housed in a common base housing (28), and **in that** a signalling device (34, 36) is further provided on or in the base housing (28) and is connected to the measuring assembly (72m, 54) in order to receive, from the measuring assembly (72m, 54), information signalling the detection of a current flow across the measuring electrode (26) which exceeds a threshold value, the signalling device (34, 36) being designed to emit an optical or audible status signal when it receives the information, the signalling device (34, 36) preferably being designed to emit the status signal by activating a warning light (34) arranged on the base housing and to deactivate the warning light (34) and/or activate a normal operation light when it does not receive the information.

9. Device (18) according to claim 8, **characterised in that** the base housing (28) has an interface (42) for transferring data to a remote data processing and display unit and/or **in that** the base housing (28) has a control panel (36) for the manual input of data and/or commands and a display field (36) to display information, and/or **in that** the measuring electrode (26) and/or the precharge electrode is/are housed on the base housing (28).

10. Device (18) according to any one of the preceding claims, **characterised in that** the measuring electrode (26) and/or the precharge electrode (20) and/or a/the wire earthing (24) of the device (18) is/are designed to surround a wire (16) or a wire core (10) at least in part.

11. Device (18) according to any one of the preceding claims, **characterised by** a discharge circuit having a discharge electrode which is arranged after the measuring electrode (26) in the flow direction of the wire (16) and which can be brought into contact with the wire coating (14), the discharge circuit connecting the discharge electrode to an ground potential in order to discharge the wire (16) into the ground potential, one of the discharge resistors which can be associated with the discharge circuit preferably being selected as a function of the magnitude of the measuring voltage and of a flow speed of the wire (16) in such a way that the wire coating (14) is completely discharged after it leaves the discharge electrode.

12. Wire manufacturing system for manufacturing a wire (16) provided with a wire coating (14), comprising:

      - a device (18) for inspecting the wire coating (14) according to any one of the preceding claims,
      - a coating station (12) in which the wire coating (14) is applied to a conductive wire core (10) of the wire (16),
      - an earth wire (24) which earths a conductive wire core (10) of the wire (16),
      - an earth voltage (25) which earths the precharge voltage supply (58v) and the measuring voltage supply (58m), the earth wire (24) being arranged before the coating station (12) in a processing direction of the wire and the precharge electrode (20) and the measuring electrode (26) being arranged after the coating station (12) in a processing direction of the wire (16), and the wire earthing (24) and the voltage earthing (25) being connected to a common ground potential.

## Revendications

1. Dispositif (18) destiné à l'examen d'un revêtement (14) d'un fil métallique (16) déplacé le long d'un sens de marche (L), dans lequel le dispositif (18) comprend :

      - une électrode de précharge (20) qui peut être amenée en contact électrique, dans une position de précharge, avec un revêtement (14) d'un fil métallique (16),
      - une alimentation en tension de précharge (58v) qui est connectée à l'électrode de précharge (20) pour appliquer une tension de précharge au revêtement de fil (14),
      - une électrode de mesure (26) qui peut être amenée en contact électrique, dans une position de mesure consécutive dans le sens de marche du fil métallique (16) à une distance (d) de la position de précharge, avec le revêtement (14) du fil métallique (16),
      - une alimentation en tension de mesure (58m) qui est connectée à l'électrode de mesure (26) pour appliquer une tension de mesure au revêtement (14), et
      - un agencement de mesure (72m) qui est aménagé pour enregistrer un flux de courant via l'électrode de mesure (26),
      dans lequel l'alimentation en tension de
      précharge (58v) et l'alimentation en tension de mesure (58m) présentent des sorties de tension (68v, 68m) séparées galvaniquement l'une de l'autre et dans lequel le dispositif (18) présente en outre un système de mise à la terre (24) de fil métallique, qui met à la terre un noyau conducteur (10) du fil métallique (16), et un système de mise à la terre de tension (25), qui met à la terre l'alimentation en tension de précharge (58v) et l'alimentation en tension de mesure (58m) ,
      **caractérisé en ce que** l'alimentation en tension de
      précharge (58v) et l'alimentation en tension de mesure (58m) sont couplées l'une à l'autre par le biais d'un circuit de surveillance (48), qui est aménagé pour une comparaison entre la tension de précharge et la tension de mesure ou entre des grandeurs représentant ces tensions,
      **en ce que** le dispositif (18) comprend un dispositif de
      diagnostic d'erreurs (48) qui est aménagé pour enregistrer un état d'erreur dans le dispositif (18) sur la base d'une tension ou d'un courant via l'électrode de précharge (20) ou/et sur la base d'une tension ou d'un courant via l'électrode de mesure (26), et
      **en ce que** le système de mise à la terre (24) de fil
      métallique et le système de mise à la terre de tension (25) sont connectées à un potentiel de masse commun.

2. Dispositif (18) selon la revendication 1, **caractérisé en ce que** l'alimentation en tension de précharge (58v) est ajustable pour régler différentes tensions de précharge et/ou l'alimentation en tension de mesure (58m) est ajustable pour régler différentes tensions de mesure.

3. Dispositif (18) selon la revendication 1 ou la revendication 2, **caractérisé par** un dispositif de positionnement pour ajuster la distance entre l'électrode de précharge (20) et l'électrode de mesure (26).

4. Dispositif (18) selon l'une quelconque des revendications précédentes, **caractérisé par** un dispositif de commande/réglage (54, 48) qui présente une entrée pour la saisie d'une grandeur de fonctionnement, dans lequel le dispositif de commande/réglage (54, 48) est aménagé pour régler la tension de précharge et/ou la tension de mesure et/ou la distance (d) entre l'électrode de précharge (20) et l'électrode de mesure (26) en fonction de la au moins une grandeur de fonctionnement saisie, dans lequel la grandeur de fonctionnement est choisie de préférence parmi la tension de précharge, la tension de mesure, la distance (d) entre l'électrode de précharge (20) et l'électrode de mesure (26), la vitesse (v) du fil métallique (16) dans le sens de marche (L) et un paramètre de caractérisation du fil métallique.

5. Dispositif (18) selon la revendication 4, **caractérisé en ce que** le circuit de surveillance (48) est aménagé pour délivrer un résultat de la comparaison sur le dispositif de commande/réglage (54, 48), et
**en ce que** le dispositif de commande/réglage (54, 48)
est aménagé pour commander/régler la tension de précharge et/ou la tension de mesure et/ou la distance entre l'électrode de précharge (20) et l'électrode de mesure (26) en fonction du résultat de la comparaison.

6. Dispositif (18) selon l'une quelconque des revendications précédentes et selon la revendication 4, **caractérisé en ce que** :

l'agencement de mesure (72m) est aménagé pour délivrer
le flux de courant d'électrode de mesure enregistré sur le dispositif de commande/réglage (54, 48), et
le dispositif de commande/réglage (54, 48) est aménagé
pour commander/régler la tension de précharge et/ou la tension de mesure et/ou la distance entre l'électrode de précharge (20) et l'électrode de mesure (26) en fonction du résultat de la comparaison.

7. Dispositif (18) selon l'une quelconque des revendications précédentes et selon la revendication 4, **caractérisé en ce que** :

le dispositif de commande/réglage (54, 48) est aménagé
pour régler la tension de précharge et/ou la tension de mesure et/ou la distance entre l'électrode de précharge (20) et l'électrode de mesure (26) de sorte que, dans le cas d'un revêtement (14) réglementaire de fil métallique, un courant minimal s'écoule par l'électrode de mesure (26) ou aucun courant du tout.

8. Dispositif (18) selon l'une quelconque des revendications précédentes, **caractérisé en ce qu'**au moins l'agencement de mesure (72m, 54) et l'alimentation en tension de mesure (58m) sont logés dans un boîtier de base (28) commun et **en ce que**, sur ou dans le boîtier de base (28), il est prévu en outre un dispositif de signalisation (34, 36) qui est connecté à l'agencement de mesure (72m, 54) pour recevoir de l'agencement de mesure (72m, 54) une information qui indique l'enregistrement d'un flux de courant dépassant une valeur de seuil via l'électrode de mesure (26) et dans lequel le dispositif de signalisation (34, 36) est aménagé pour émettre, à la réception de l'information, un signal de notification optique ou acoustique, dans lequel le dispositif de signalisation (34, 36) est aménagé de préférence pour émettre le signal de notification par activation d'une lumière d'avertissement (34) agencée sur le boîtier de base et, en cas de non-réception de l'information, pour désactiver la lumière d'avertissement (34) et/ou activer une lumière de fonctionnement normal.

9. Dispositif (18) selon la revendication 8, **caractérisé en ce que** le boîtier de base (28) présente une interface (42) pour transmettre des données à une unité distante de traitement et d'affichage de données, et/ou
**en ce que** le boîtier de base (28) présente un tableau
de commande (36) pour la saisie manuelle de données et/ou des commandes, ainsi qu'un zone d'affichage (36) pour afficher des informations, et/ou
**en ce que** l'électrode de mesure (26) et/ou l'électrode
de précharge est ou sont placées sur le boîtier de base (28).

10. Dispositif (18) selon l'une quelconque des revendications précédentes, **caractérisé en ce que** l'électrode de mesure (26) et/ou l'électrode de précharge (20) et/ou le/un système de mise à la terre (24) de fil métallique du dispositif (18) est ou sont aménagés pour enrober au moins en partie un fil métallique (16) ou un noyau de fil métallique (10).

11. Dispositif (18) selon l'une quelconque des revendications précédentes, **caractérisé par** un circuit de décharge avec une électrode de décharge, qui est aménagée dans le sens de marche du fil métallique (16) après l'électrode de mesure (26) et qui peut être amenée en contact avec le revêtement de fil métallique (14), dans lequel le circuit de décharge connecte l'électrode de décharge à un potentiel de masse pour évacuer la charge du fil métallique (16) vers le potentiel de masse, dans lequel, de préférence, une résistance de décharge affectée au circuit de décharge est choisie en fonction de la grandeur de la tension de mesure et d'une vitesse de marche du fil métallique (16) de sorte que le revêtement (14) de fil métallique soit déchargé complètement après avoir quitté l'électrode de décharge.

12. Installation de fabrication de fil métallique pour fabriquer un fil métallique (16) pourvu d'un revêtement (14), comprenant :

    - un dispositif (18) destiné à l'examen du revêtement de fil métallique (14) selon l'une quelconque des revendications précédentes,
    - un poste de revêtement (12), dans lequel le revêtement (14) est appliqué sur un noyau conducteur (10) du fil métallique (16),
    - un système de mise à la terre (24) du fil métallique, qui met à la terre un noyau conducteur (10) du fil métallique (16),
    - un système de mise à la terre de tension (25), qui met à la terre l'alimentation en tension de précharge (58v) et l'alimentation en tension de mesure (58m),
    dans laquelle le système de mise à la terre (24) du
    fil métallique est agencé dans le sens de traitement du fil métallique avant le poste de revêtement (12) et l'électrode de précharge (20) ainsi que l'électrode de mesure (26) sont agencées dans le sens de traitement du fil métallique (16) après le poste de revêtement (12), et
    dans laquelle le système de mise à la terre (24) du
    fil métallique et le système de mise à la terre de tension (25) sont connectés à un potentiel de masse commun.

Fig. 1

Fig. 2

Fig. 3a

Fig. 3b

VM/VL

1.00

0.95

0.90

0.80

0.75

2    4    6    8    10    d [m]

Fig. 4a

VM/VL

1.000

0.995

0.990

0.985

0.980

0.975

0.970

0.2    0.4    0.6    0.8    1.0    d [m]

Fig. 4b

Fig. 5

Fig. 6

Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- CH 434460 A
- DE 10239460 A1